# EUROPÄISCHE PATENTSCHRIFT

(11) **EP 3 349 082 B1**
(45) Veröffentlichungstag und Bekanntmachung des Hinweises auf die Patenterteilung: **31.07.2019**
(21) Anmeldenummer: 17151591.9
(22) Anmeldetag: 16.01.2017
(51) Int. Cl.: G05B 19/05

(54) **SYSTEM ZUR ABSCHALTBAREN SIMULATION VON ANLAGEN ODER MASCHINEN INNERHALB VON SPEICHERPROGRAMMIERBAREN STEUERUNGEN**
SYSTEM FOR DEACTIVATABLE SIMULATION OF INSTALLATIONS OR MACHINES WITHIN PROGRAMMABLE CONTROLLERS
SYSTÈME DESTINÉ À LA SIMULATION INTERRUPTIBLE D'INSTALLATIONS OU DE MACHINES DANS DES COMMANDES PAR PROGRAMME ENREGISTRÉ

(43) Veröffentlichungstag der Anmeldung: 18.07.2018
(73) Patentinhaber: Siemens Aktiengesellschaft, 80333 München (DE)
(72) Erfinder: Ermler, Rene, 91058 Erlangen (DE); Krebs, Cornelia, 90607 Rückersdorf (DE); Neidig, Jörg, 90419 Nürnberg (DE); Quiros Araya, Gustavo, Plainsboro, NJ 08536 (US)

(56) Entgegenhaltungen:
- EP-A1- 2 687 928
- WO-A1-2012/031859
- WO-A1-2015/124170

## Beschreibung

Die Erfindung betrifft ein System und einen Simulator zur abschaltbaren Simulation von Anlagen oder Maschinen innerhalb von speicherprogrammierbaren Steuerungen (SPS) mit einer Anlagen-Schnittstelle für einen Produktivmodus, die zur Ausgabe von Anlagen-Steuerdaten an die Anlage und zum Empfang von Anlagendaten von der Anlage vorhanden ist, und mit einer von der Anlagen-Schnittstelle separaten weiteren Schnittstelle für einen Simulationsmodus.

Im Umfeld der speicherprogrammierbaren Steuerungen (SPS) wird Programmcode geschrieben, der Anlagen oder Maschinen steuert. Dieser Code muss getestet werden. Um realistisch zu testen, muss jedoch die Umgebung, in der die Steuerung später arbeiten wird, nachgebildet werden. Dazu muss aus den Signalen, welche die Steuerung an die Anlage oder Maschine sendet, eine Antwort erzeugt werden, deren Signale der Realität insoweit entsprechen wie es für den Test notwendig ist. Dazu wird entweder eine Simulationsumgebung verwendet oder es wird das Programm in der Steuerung so modifiziert, dass es die erwarteten Signale selbst generiert.

In der Regel wird bei der Inbetriebnahme die Anlage/Maschine nach und nach aufgebaut und verwendet. Um die Funktionsfähigkeit der Steuerung und der schon vorhandenen Anlagenteile inkrementell zu überprüfen, ist es erforderlich, fehlende Ausschnitte Arbeitsumgebung zu simulieren.

Probleme bei der Verwendung von Simulationsumgebungen sind üblicherweise folgende: Der Aufwand, eine Simulationsumgebung aufzubauen, ist aus mehreren Gründen erheblich, da Simulationssysteme Einarbeitung erfordern, weil sie in anderen Sprachen programmiert werden, und da die Integration einer Steuerung in ein Simulationssystem aufwändig ist, weil die Signale der beiden Systeme einzeln und oft "von Hand" zugeordnet werden müssen. Ferner steht das Simulationssystem oft nur in der Entwicklung zur Verfügung, aber nicht bei späteren Änderungen oder Fehlerbeseitigungen in der Anlage. Schließlich entstehen zusätzliche Kosten, da Simulationssysteme zusätzliche Computersysteme erfordern und die Software auch Geld kostet.

Andererseits bringt auch die Modifikation des Steuerungscodes zum Zweck der Simulation einige Probleme mit sich: Der Einbau von Testlogik erfordert Änderung am Steuerungscode, was eine zusätzliche Fehlerquelle darstellt und den Steuerungscode unklarer macht, d. h. es wird nicht mehr der Originalcode getestet, sondern ein angepasster Code. Die Testlogik wird im Produktivbetrieb gar nicht benötigt bzw. sie kann versehentlich aktiviert werden oder das Deaktivieren nach der Inbetriebsetzung vergessen werden, was eine Fehlerquelle darstellt, und im Testbetrieb verfälscht die zusätzliche Testlogik das Timing, da der zusätzliche Code ja auch ausgeführt werden muss.

Bislang sind folgende drei grundsätzliche Lösungsansätze bekannt:
a) Verwendung von zusätzlichen Simulationsprodukten:
   Es gibt eine breite Auswahl verschiedener Produkte für verschiedene Einsatzgebiete wie AMESim (Siemens), SIMIT (Siemens), Plant Simulation (Siemens), MATLAB/Simulink (Mathworks), usw. Die speicherprogrammierbare Steuerung wird hier üblicherweise als Hardware-in-the-Loop oder Software-in-the-Loop Technik eingebettet. Im ersten Fall kommt spezielle Hardware zum Einsatz, welche die Signale des Simulationsprodukts anbindet, im zweiten Fall besitzt die Software-SPS ein dafür vorgesehene Simulations-API, also eine entsprechende Programmierschnittstelle.
b) Modifikation von Bausteinen, also von Programmierobjekte in der speicherprogrammierbaren Steuerung, durch Verknüpfung mit einer Simulationsbedingung, wobei die Bausteine so abgeändert werden, dass in Abhängigkeit von einem Flag alternative Code-Abschnitte angesprungen werden. Dabei werden z.B. bestimmte Eingangssignale ignoriert oder durch geänderten Bausteincode gesetzt. Der Zusatzcode wird im Laufe der Inbetriebnahme für den beabsichtigten Betrieb aus dem Programm entfernt, damit das gewünschte Verhalten der Steuerung gegeben ist. Dies erfolgt jedoch unsystematisch und ist nicht zu 100% durch anschließende Tests überprüfbar. Mitunter kommt es vor, dass nicht entfernter Zusatzcode nach der Inbetriebnahme der Steuerung falsche Eingangssignale vortäuscht.
c) Programmierung spezieller Simulationsbausteine, die das Verhalten der Anlage oder Maschine mit SPS-Code nachahmen: Diese Bausteine müssen wie die Regelungsbausteine von der SPS ausgeführt werden und generieren die Antwortsignale aus den Steuerungssignalen des Reglers. Das Problem der veränderten Laufzeit wird dabei in Kauf genommen.

Aus der europäischen Patentanmeldung EP 2 980 661 A1 (2013E09254DE), Siemens AG, Rene Ermler, Andreas Matis, Gustavo Quiros Araya, ist ein elektronisches Steuerungsgerät mit einer Steuereinrichtung zum Ablauf eines Steuerungsprogramms zur Steuerung einer Anlage und mit einer Anlagen-Schnittstelle zur Ausgabe von Anlagen-Steuerdaten an die Anlage und zum Empfang von Anlagendaten von der Anlage bekannt, wobei das Steuerungsgerät zum Betrieb in einem ein- und ausschaltbaren Emulationsmodus zur Steuerung einer Anlagensimulation durch das Steuerungsprogramm eingerichtet und ausgebildet ist, und wobei in dem Emulationsmodus eine von der Anlagen-Schnittstelle separate Emulations-Schnittstelle zur Ausgabe der Anlagen-Steuerdaten und zum Empfang von Daten von der Anlagensimulation vorhanden ist.

Aus der WO 2015/124170 A1 ist ein Verfahren zum Emulieren einer speicherprogrammierbaren Steuerung durch Bereitstellen einer Recheneinrichtung mit einem bezüglich einer an die speicherprogrammierbare Steuerung gestellte Echtzeitanforderung ungenügenden Betriebssystem bekannt. Dabei erfolgt ein Abbilden einer realen Zeitdauer auf eine virtuelle Zeitdauer anhand einer vorbestimmten Funktion, wobei ein Vorbestimmen eines Grenzwerts für die zum Emulieren zumindest eines Programmzyklus eines Programms der speicherprogrammierbaren Steuerung benötigte virtuelle Zeitdauer vorgesehen ist und ein Emulieren des zumindest eines Programmzyklus mit der Recheneinrichtung und Überprüfen eines Vorhandenseins einer Zykluszeitüberschreitung des emulierten Programmzyklus in Abhängigkeit von dem Grenzwert erfolgt.

Die EP 2 687 928 A1 offenbart ein Unterstützungsprogramm für ein Steuergerät, welches eine Arithmetikeinheit dazu veranlasst, die Erfassung einer Gesamtausführungszeit durchzuführen, indem eine Gesamtausführungszeit erfasst und ausgegeben wird. Die Gesamtausführungszeit ist eine verstrichene Zeit, welche bis zur erfolgten Ausführung eines Steuerprogramms in einem Ausführungszyklus angefallen ist, da der Ausführungszyklus gestartet wird, wenn ein Steuergerät das Steuerungsprogramm gemäß einer Ausführungspriorität und dem Ausführungszyklus ausführt. Die Gesamtausführungszeit ist dabei eine Zeit, die in der Steuerung gemessen wird oder eine Zeit, die in einer Steuerungsunterstützungsvorrichtung geschätzt wird.

Die WO 2012/031859 A1 betrifft eine Steuervorrichtung zum Steuern von Einrichtungen einer Fabrikanlage, umfassend eine Steuereinheit und eine Simulationseinrichtung, wobei sich mittels der Steuereinheit Einrichtungen der Fabrikanlage gemäß einer vorbestimmten Steuerroutine in einem Steuerzyklus steuern lassen und mittels der Simulationseinrichtung der Steuervorrichtung ein synchron zu dem Zeitraster des Steuerzyklus erfolgendes Simulieren eines Betriebs der Einrichtungen vorgesehen ist.

Die der Erfindung zu Grunde liegende Aufgabe besteht nun darin, einen System zur abschaltbaren Simulation von Anlagen oder Maschinen innerhalb von speicherprogrammierbaren Steuerungen anzugeben, bei den die oben genannten Nachteile möglichst vermieden werden.

Diese Aufgabe wird durch die Merkmale des Patentanspruchs 1 erfindungsgemäß gelöst. Die weiteren Ansprüche betreffen bevorzugte Ausgestaltungen der Erfindung.

Die Erfindung betrifft im Wesentlichen ein System zur abschaltbaren Simulation von Anlagen oder Maschinen innerhalb von speicherprogrammierbaren Steuerungen, bei dem Steuerungsprogramm und Simulationsprogramm innerhalb derselben Ablaufumgebung konsequent getrennt sind, wobei die Zugriffsrichtung für den Ein-/Ausgangsspeicherbereich im Normalbetrieb bzw. deren konsequente Umkehrung im Simulationsanteil sichergestellt sind, und bei der
das Simulationsprogramm zwischen den Programmzyklen ausgeführt wird, wobei eine virtuelle Uhr während der Simulation angehalten wird. Hiermit werden durch den Test eines unveränderten Anwenderprogramms in der SPS Fehler in der Inbetriebnahme- oder Testphase durch Codeänderungen vermieden und durch ein Zeitverhalten wie in der echten Anlage, insbesondere bei Tests von Timern und bei Race-Conditions, wird eine höhere Programmqualität durch bessere Testergebnisse erreicht. Eine Verwendung mehrerer Prozessorkerne ist ebenfalls möglich. Da der Simulator in derselben Steuerung wie der eigentliche Steuerungscode läuft, ist keine zusätzliche Testhardware erforderlich und durch eine schnelle Testbetrieb/Produktivbetrieb-Umschaltung wird darüber hinaus eine Zeitersparnis erreicht. Bei Verbleib des Simulators auf der Steuerung, sind im Störungsfall schnell Testszenarien zur Hand.

Nachfolgend wird die Erfindung anhand von in der Zeichnung dargestellten Ausführungsbeispielen näher erläutert.

### Dabei zeigt

- Figur 1: eine Übersichtsdarstellung zur Erläuterung der Erfindung bezüglich Engineeringsystem und Speicherprogrammierbarer Steuerung,
- Figur 2: eine Prinzipdarstellung zur Erläuterung der Erfindung hinsichtlich Trennung von Produktivcode und Simulationscode sowie dem Informationsaustausch mit dem Datenspeicher und
- Figur 3: eine Ablaufdiagramm zur Erläuterung der Erfindung hinsichtlich der zeitlichen Abläufe im Produktivteil, im Simulationsteil und in der virtuellen Uhr.

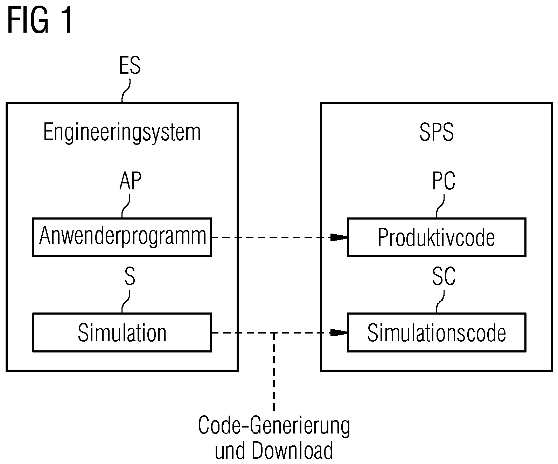

**Figur 1** zeigt eine Übersichtsdarstellung zur Erläuterung der Erfindung bezüglich eines Engineeringsystems **ES** und Speicherprogrammierbarer Steuerung **SPS,** wobei ein im Engineeringsystem vorhandenes Anwendungsprogramm **AP** in der Speicher-programmierbaren Steuerung **SPS** zu einem Produktivcode **PC** führt und getrennt davon im Engineeringsystem **ES** aus einem Simulationsprogramm **S** ein Code generiert und als Simulationscode **SC** separat ebenfalls in die speicherprogrammierbare Steuerung **SPS** geladen wird.

Der Simulationscode **SC** ist mit einer SPS-Sprache programmiert und wird durch einen vorteilhafterweise in der speicherprogrammierbaren Steuerung **SPS** integrierten IO-Simulator ausgeführt.

Der IO-Simulator ist Teil der Steuerung, läuft im selben Kontext und kann innerhalb des Steuerungssystems auf die internen Datenspeicher zugreifen.

Zur Trennung der Zuständigkeiten werden die beiden Teile "Produktivcode" und "Simulationscode" voneinander unterschieden. Die SPS führt den Simulationscode ausschließlich durch den IO-Simulator. Die direkte bzw. versehentliche Ausführung von Simulationscode durch die SPS wird technisch verhindert. Nur der IO-Simulator bekommt noch die u. g. Sonderrechte wie z.B. Modifizieren von Eingangssignalen.

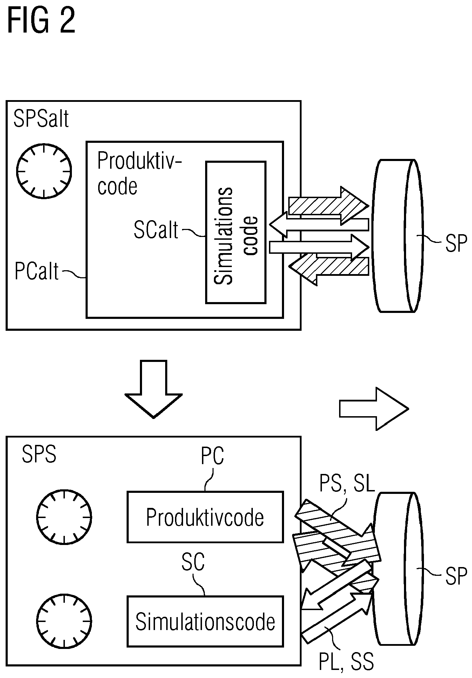

**Figur 2** zeigt eine Prinzipdarstellung zur Erläuterung der Erfindung. Zur besseren Verdeutlichung der Unterschiede ist im oberen Teil von **Figur 2** eine Speicherprogrammierbare Steuerung **SPSₐₗₜ** mit einem bisherigen Produktivcode **PCalt,** der auch den bisherigen Simulationscode **SCalt** enthält, dargestellt. Im Gegensatz dazu ist im unteren Teil von **Figur 2** eine erfindungsgemäße Speicherprogrammierbare Steuerung **SPS** mit einem Produktivcode **PC** und einem separaten Simulationscode **SC** dargestellt, wobei der Produktivcode **PC** aus einem Speicher **SP** Eingangs-Informationen liest **PL** und Ausgangs-Informationen in den Speicher **SP** schreibt **PS** und wobei der Simulationscode **SC** umgekehrt aus dem Speicher **SP** zumindest einen Teil der Ausgangs-Informationen liest **SL** und neue Eingangs-Informationen in den Speicher **SP** schreibt **SS.**

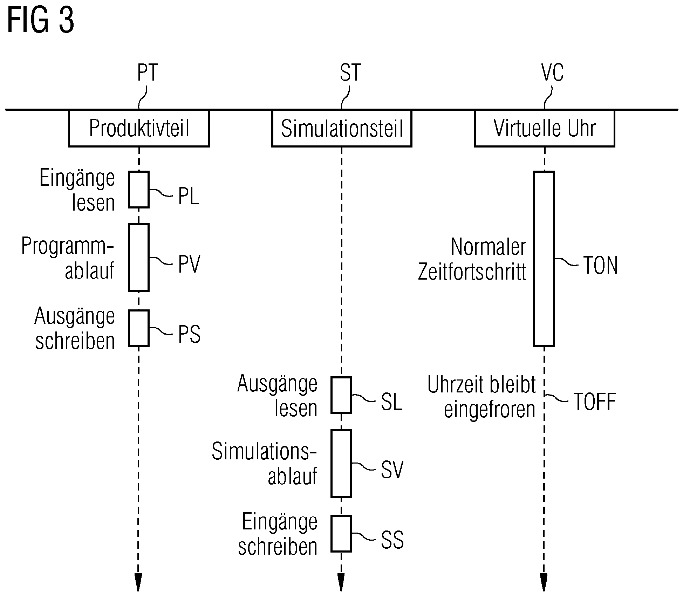

**Figur 3** zeigt ein Ablaufdiagramm zur Erläuterung der zeitlichen Abläufe im Produktivteil **PT,** im Simulationsteil **ST** und in der virtuellen Uhr **VC** in einem erfinderischen System.

Im Produktivmodus bzw. im Produktivteil **PT** werden aus dem Speicher **SP** Eingangs-Informationen gelesen **PL,** während eines jeweiligen Programmablaufs zumindest ein Teil dieser Eingangs-Informationen verarbeitet **PV** und dann als Ausgangs-Informationen in den Speicher **SP** geschrieben **PS.**

Das unveränderte Anwenderprogramm berechnet die neuen Ausgänge auf Basis der Eingänge. Während der Berechnung läuft die virtuelle Uhr **VC** normal weiter **TON,** d.h. das Timing des Programmablaufs ist unverändert. Im Produktivmodus wird keine Simulation berechnet. Der Steuerungscode wird in Echtzeit ausgeführt.

Im Simulations-/Inbetriebnahmemodus bzw. im Simulationsteil **ST** werden aus dem Speicher **SP** Ausgangs-Informationen gelesen **SL,** zumindest ein Teil dieser Ausgangs-Informationen verarbeitet **SV** und dann als Eingangs-Informationen in den Speicher **SP** geschrieben **SS.**

Im Simulationsteil **ST** greifen die Simulationsbausteine des IO-Simulators entgegengesetzt wie Produktivteil PT auf die IO-Speicherbereiche zu. Die Simulation wird zwischen den Programmzyklen gerechnet und verfälscht damit nicht das normale Betriebsverhalten. Der SPS-Code wird auf Basis der virtuellen Uhr **VC** ausgeführt, die als Stoppuhr funktioniert und während der Simulation nicht fortschreitet **TOFF.** Somit ändert sich durch die Ausführung des Simulationscodes auch das Timing des eigentlichen Programmes nicht. Die Ausführung der Simulationsbausteine ist je nach Szenario (Entwicklung/ Test/Produktion) deaktivierbar.

Nach einem Ablauf des Anwenderprogramms stoppt die virtuelle Uhr **VC** und der Simulationslauf beginnt. Die Simulation berechnet die neuen Eingänge auf Basis der Ausgänge. Danach beginnt der Zyklus von neuem mit dem Ablauf des Anwenderprogramms und der Fortsetzung des normalen Zeitablaufs.
Durch die virtuelle Uhr wird die Simulation praktisch "zwischen" den Zyklen berechnet, wodurch die Simulationsgenauigkeit verbessert wird, da damit das Timing (Zykluszeiten, Jitter, usw.) nicht verfälscht wird.
Die Laufzeiten der Simulation sind nicht relevant für die Betrachtung der Programmlaufzeit.

Durch die Erfindung ist es nicht notwendig, Programmteile zu entfernen, da der IO-Simulator durch den Wechsel des Betriebsmodus einfach abgeschaltet wird, wodurch bspw. die Unübersichtlichkeit der sonst erforderlichen Programmergänzungen entfällt. Das "Abschalten" des IO-Simulators deaktiviert alle Anteile des Simulationscodes und damit jegliche unbeabsichtigte Manipulation der Prozessdaten. Die Uhr läuft permanent.

Zusätzlich ist es möglich, die Verwendung der Simulations- und Inbetriebnahmebausteine einzeln aktiv zu schalten, so dass Teilbereiche der Anlage simuliert werden können, während andere Teile schon fertiggestellt sind und direkt verwendet werden. Auch stehen die Simulationsbausteine nach Inbetriebnahme der Anlage für einen späteren Umbau zur Verfügung. Hier ändert sich das Zeitverhalten durch den zusätzlichen Aufwand der Simulation von Teilbereichen. Das Stoppen der Uhr ist hier nicht mehr möglich, da die Zeitbasen der Simulation und der realen Anlagenteile dann voneinander abweichen.

Optional können Anwenderprogramm und Simulator auch auf separaten Prozessorkernen der SPS ausgeführt werden.

Ein entsprechender Simulator kann als separates Produkt verkauft werden, z.B. mit separaten Lizenzen für Engineering und Laufzeit.

Der IO-Simulator kann durch einen einfachen Mechanismus an einer Stelle deaktiviert werden. Das System ist so konzipiert, das bei deaktiviertem IO-Simulator mit Sicherheit kein Simulationscode mehr ausgeführt wird.
Die Ausführung des Simulationscodes ist von der Ausführung des Produktivcodes getrennt, so dass Verwechslung ausgeschlossen ist.

## Patentansprüche

1. System zur abschaltbaren Simulation von Anlagen oder Maschinen innerhalb einer speicherprogrammierbaren Steuerung (SPS), umfassend
- einen Simulationsteil (ST) und einen davon separaten Produktivteil (PT), wobei jeweils zwischen zwei Programmabläufen (P1..P3) in dem Produktivteil (PT) jeweils ein Simulationsablauf (S1..S3) in dem Simulationsteil (ST) vorgesehen ist,
- wobei der Produktivteil (PT) aus dem Speicher (SP) Eingangs-Informationen liest (PL), zumindest einen Teil dieser Eingangs-Informationen verarbeitet (PV) und dann als Ausgangsinformationen in den Speicher schreibt (PS) und
- wobei der Simulationsteil (ST) aus dem Speicher (SP) Ausgangsinformationen liest (SL), zumindest einen Teil dieser Ausgangsinformationen verarbeitet (SV) und dann als Eingangs-Informatinen in den Speicher schreibt (SS), **gekennzeichnet durch**
- eine speicherprogrammierbare Steuerung (SPS) mit einem in dem Produktivteil (PT) ablaufenden Produktivcode (PC) eines Anwenderprogramms (AP) und einem in dem Simulationsteil (ST) ablaufenden durch ein Simulationsprogramm (S) erzeugten Simulationscode (SC), und
- eine virtuelle Uhr (VC), welche zum normalen Ablauf (TON) im Produktivteil (PT) und zum Anhalten (TOFF) im Simulationsteil (ST) ausgebildet ist.

2. System nach Anspruch 1, wobei
- die aus dem Speicher (SP) lesbaren (PL) Eingangs-Informationen zumindest teilweise während eines jeweiligen Programmablaufs verarbeitbar (PV) sind, und
- die aus dem Speicher (SP) lesbaren (SL) Ausgangs-Informationen zumindest teilweise während eines Simulationsablaufs verarbeitbar (SV) sind.

3. System nach Anspruch 1 oder 2,
bei dem die Anlage in Teilbereiche unterteilt ist und für diese Teilbereiche entsprechende Simulations-/InbetriebnahmeBausteine vorhanden sind und
bei dem noch nicht fertiggestellte Teilbereiche der Anlage dadurch simulierbar sind, dass die entsprechende Simulations-/Inbetriebnahme-Bausteine zur einzelnen Aktivschaltung und andere bereits fertiggestellte Teilbereiche zur direkten Verwendung vorgesehen sind.

4. System nach einem der vorhergehenden Ansprüche,
bei dem die speicherprogrammierbaren Steuerung (SPS) Prozessorkerne aufweist, auf welchen das Anwenderprogramm (AP) und das Simulationsprogramm (S) jeweils separat ausführbar sind.

## Claims

1. System for the disengageable simulation of installations or machines within a programmable logic controller (PLC), comprising
- a simulation part (ST) and a productive part (PT) separate therefrom, wherein a respective simulation sequence (S1..S3) in the simulation part (ST) is provided between two respective program sequences (P1..P3) in the productive part (PT),
- wherein the productive part (PT) reads (PL) input information from the memory (SP), processes (PV) at least one portion of said input information and then writes (PS) it to the memory as output information, and
- wherein the simulation part (ST) reads (SL) output information from the memory (SP), processes (SV) at least one portion of said output information and then writes (SS) it to the memory as input information,
**characterized by**
- a programmable logic controller (PLC) having a productive code (PC), running in the productive part (PT), of a user program (AP) and having a simulation code (SC) running in the simulation part (ST) and produced by a simulation program (S), and
- a virtual clock (VC) that is configured for normal operation (TON) in the productive part (PT) and for stoppage (TOFF) in the simulation part (ST).

2. System according to Claim 1, wherein
- the input information that is readable (PL) from the memory (SP) is at least partly processable (PV) during a respective program sequence, and
- the output information that is readable (SL) from the memory (SP) is at least partly processable (SV) during a simulation sequence.

3. System according to Claim 1 or 2,
in which the installation is divided into subregions and appropriate simulation/startup modules are present for these subregions, and
in which as yet unfinished subregions of the installation are simulatable by virtue of the applicable simulation/startup modules being provided for individual activation and other, already finished, subregions being provided for direct use.

4. System according to one of the preceding claims,
in which the programmable logic controller (PLC) has processor cores on which the user program (AP) and the simulation program (S) are each separately executable.

## Revendications

1. Système destiné à la simulation interruptible d'installations ou de machines dans une commande par programme enregistré (SPS), comprenant :
- une partie de simulation (ST) et une partie productive (PT) qui en est séparée, respectivement entre deux déroulements de programme (P1 ... P3) dans la partie productive (PT) étant respectivement prévu un déroulement de simulation (S1 ... S3) dans la partie de simulation (ST),
- la partie productive (PT) lisant (PL) des informations d'entrée de la mémoire (SP), traitant (PV) au moins une partie de ces informations d'entrée et les écrivant (PS) alors dans la mémoire en tant qu'informations de sortie et
- la partie de simulation (ST) lisant (SL) des informations de sortie de la mémoire (SP), traitant (SV) au moins une partie de ces informations de sortie et les écrivant (SS) alors dans la mémoire en tant qu'informations d'entrée, **caractérisé par** :
- une commande par programme enregistré (SPS) avec un code productif (PC) d'un programme utilisateur (AP), lequel code tourne dans la partie productive (PT), et un code de simulation (SC) généré par un programme de simulation (S) et tournant dans la partie de simulation (ST) et
- une horloge virtuelle (VC) qui est réalisée pour le déroulement normal (TON) dans la partie productive (PT) et pour interruption (TOFF) dans la partie de simulation (ST).

2. Système selon la revendication 1,
- les informations d'entrée qui peuvent être lues (PL) hors de la mémoire (SP) pouvant être traitées (PV) au moins en partie pendant un déroulement de programme respectif et
- les informations de sortie qui peuvent être lues (SL) hors de la mémoire (SP) pouvant être traitées (SV) au moins en partie pendant un déroulement de simulation.

3. Système selon la revendication 1 ou 2, dans lequel l'installation est subdivisée en sous-parties et on a des composants de simulation / de mise en service correspondants pour ces sous-parties et dans lequel des sous-parties non encore terminées de l'installation peuvent être simulées par le fait que les composants de simulation / de mise en service correspondants sont prévus pour l'activation isolée et d'autres sous-parties déjà terminées, pour l'utilisation directe.

4. Système selon l'une des revendications précédentes, dans lequel la commande par programme enregistré (SPS) comporte des coeurs de processeur sur lesquels le programme utilisateur (AP) et le programme de simulation (S) peuvent être exécutés chacun séparément.
